# EUROPÄISCHE PATENTSCHRIFT

(11) **EP 0 450 445 B1**
(45) Veröffentlichungstag und Bekanntmachung des Hinweises auf die Patenterteilung: **27.05.1998**
(21) Anmeldenummer: 91104654.8
(22) Anmeldetag: 25.03.1991
(51) Int. Cl.: H04N 9/64, H04N 9/475, H04N 9/89

(54) **Digitale Fernsehsignalverarbeitungsschaltung mit orthogonalem Ausgangstakt**
Digital television signal processing circuit with orthogonal output clock
Circuit de traitement de signal de télévision numérique avec horloge de sortie orthogonale

(30) Priorität: 06.04.1990 DE 4011241
(43) Veröffentlichungstag der Anmeldung: 09.10.1991
(73) Patentinhaber: Micronas Intermetall GmbH, 79108 Freiburg (DE)
(72) Erfinder: Mehrgardt, Sönke, Dr.rer.nat., W-7806 March-Neuershausen (DE); Desor, Hans-Jürgen, Dipl.-Ing., W-7803 Gundelfingen (DE)

(56) Entgegenhaltungen:
- EP-A- 160 398
- EP-A- 166 428
- DE-A- 3 807 739
- GB-A- 2 087 193
- US-A- 4 612 568
- US-A- 4 646 136
- PATENT ABSTRACTS OF JAPAN vol. 8, no. 111 (E-246)(1548) 24. Mai 1984

## Beschreibung

Bei digitalen Fernsehsignalverarbeitungsschaltungen gibt es prinzipiell drei verschiedene Möglichkeiten des Abtastsystems:
a) Beim zeilenverkoppelten System befinden sich die auf den Bildschirm bezogenen abgetasteten Bildpunkte aller Bildzeilen in genauen vertikalen Linien untereinander angeordnet.
b) Beim farbträgerverkoppelten System, beispielsweise mit der vierfachen Farbhilfsträgerfrequenz, liegen die abgetasteten Bildpunkte im allgemeinen nur näherungsweise untereinander. Dies ist bekanntlich eine Folge der nichtganzzahligen Verkämmung von Farbhilfsträgerfrequenz und Zeilenfrequenz und dem 25 Hz Frequenzoffset beim PAL-Farbfernsehstandard.
c) Eine weitere Möglichkeit des Abtastsystems bildet der asynchrone Takt, der weder mit der Zeile noch mit dem Farbträger verkoppelt ist.

Üblicherweise erfolgt die Digitalisierung und die Rückwandlung mit dem selben Takt, unter Umständen aber auch mit Takten die sich um den Faktor 2 oder 4 voneinander unterscheiden, beispielsweise bei verschiedenen Verfahren der Flimmerreduktion.

Ein Beispiel für ein rein digitales Verfahren der Phasenkorrektur ist in GB-A 2 087 193 beschrieben. Dort werden die digitalisierten Videosignalwerte synchron zum Digitalisierungstakt in einen Bildspeicher zur Zwischenspeicherung adressenweise geschrieben. Das Lesen der gespeicherten Daten erfolgt synchron zum Digitalisierungstakt, wobei mittels eines Adressengenerators über die Ausleseadressen die Phasenkorrektur der Videosignalwerte gesteuert ist und als Bezugswert für die Phasenkorrektur ein mit der Bildwiedergabeeinrichtung gekoppelter Referenztakt dient.

Verfahren zur Bildverbesserung, beispielsweise durch mehrdimensionale Filteralgorithmen, fordern, daß die zu verarbeitenden Videosignale orthogonal abgetastet sind. Das heißt, daß die auf den Bildschirm bezogenen Abtastwerte verschiedener Zeilen oder Bilder genau senkrecht untereinander stehen müssen. Bei dem System a) ist diese Forderung bereits durch die Abtastung erfüllt; bei b) und c) muß eine Interpolation der Videosignale ausgeführt werden, die die Daten auf ein orthogonales Abtastraster hin korrigiert. Hierzu dient ein Skew-Filter. Der Parameter der Dateninterpolation ist der Phasenversatz zwischen einem nur gedachten zeilenverkoppelten Abtasttakt und dem tatsächlichen Abtasttakt. Der Phasenversatz wird dabei in einer ersten Phasenregelschleife digital bestimmt und als Skew-Wert ausgegeben.

Wenn die Digitalisierung und Rückwandlung mit dem selben Abtasttakt erfolgt, dann muß nach vollzogener Filteroperation bei nicht zeilenverkoppelten Takten die orthogonale Struktur der Videodaten wieder aufgehoben werden, indem die Daten durch eine reziproke Skew-Operation rechnerisch in ihre ursprüngliche Phasenlage zurückgeführt werden.

In analogen wie digitalen Fernsehsignalverarbeitungsschaltungen wird die Horizontalsynchronisation mit zwei Phasenregelschleifen (= PLL 1 und PLL 2) durchgeführt. Mit der ersten Phasenregelschleife PLL 1 wird ein Horizontal-Referenztakt hr erzeugt, der genau die gleiche Zeilenfrequenz wie das zu verarbeitende FBAS-Signal (= Farb-Bild-Austast-Synchron-Signalgemisch) aufweist, jedoch ohne dessen Phasenzittern. Beim Videorecorderbetrieb können nämlich Phasenschwankungen bis zu 2x10⁻⁶sec. auftreten. Die zweite Phasenregelschleife PLL 2 hat die Aufgabe, die exakte Position des Leuchtpunktes auf der Röhre unabhängig von beispielsweise verschiedenen Bauteileeigenschaften, Netzspannung oder Temperatur exakt beizubehalten. Dabei ist die Zeilenendstufe selbst als Resonanzkreis ausgebildet, der auf störende Eingriffe mit Regelschwingungen reagiert.

Die im allgemeinen üblichen Verfahren, Phasenfehler des FBAS-Signals über einen Phasenschieber im zweiten Phasenregelkreis PLL 2 auszugleichen, weisen den Nachteil auf, daß sich diese Regelung dort als Störsignal auswirkt und eventuell Regelschwingungen und Überschwinger auslöst.

Somit ergibt sich das Problem, daß auf der einen Seite Phasenänderungen der Videosignalquelle, insbesondere beim Videorecorder, möglichst schnell auf die Ablenkung gebracht werden müssen, um dort die Zeilenendstufe an die neue Phasenlage anzupassen. Das bedingt eine starke Kopplung der beiden Regelschleifen PLL 1 und PLL 2. Auf der anderen Seite sollen Rauschanteile der Videosignalquelle möglichst gut unterdrückt werden, was eine schwache Ankopplung der Zeilenendstufe an die momentane Phasenlage des Synchronimpulses begünstigen würde.

Es ist daher Aufgabe der in den Ansprüchen gekennzeichneten Erfindung, eine möglichst weitgehende Entkopplung zwischen der Videosignalquelle und der Bildwiedergabe zu bewirken, wobei der Wiedergabetakt unabhängig vom Digitalisierungstakt zeilenverkoppelt sein soll.

Der Grundgedanke der Erfindung besteht darin, den gesamten Phasenfehler des eingangsseitigen FBAS-Signals durch Interpolation und variable Signalverzögerung auszugleichen. Dabei werden die hochfrequenten und als Bildunruhe störenden Phasenfehler der Zeilenendstufe, die z.B. durch Spannungseinbrüche der Zeilenablenkspannung infolge von hohen Bildkontrasten bedingt sind, ebenfalls auf der Signalseite und nicht auf der Ablenkungsseite korrigiert. Die Korrektur erfolgt durch eine zusätzliche variable Verzögerung der Videosignale. Es handelt sich dabei um eine Kompensation, da die Verzögerungszeit vom Zeilenrückschlagsignal gesteuert ist - eine Regelschleife ist für diese Signalverzögerung nicht vorhanden.

Die niederfrequenten Phasenfehler der Zeilenendstufe, z.B. infolge Temperatureffekten, werden durch die Phasenregelung der Zeilenendstufen-Regelschleife PLL 2 ausgeregelt, die als autonomes System möglichst unabhängig und frequenzstabil arbeiten soll. Die Beeinflussung durch die Quelle soll nur langsam sein, was eine schwache Ankopplung bedeutet. Die auf den Digitalisierungs- und Wiedergabetakt bezogene Entkopplung und Verzögerung der Daten erfolgt dabei in einem Zweitor-Schreib-Lesespeicher, der synchron zum Digitalisierungstakt eingeschrieben und synchron zum Wiedergabetakt ausgelesen wird.

Die Erfindung wird nun anhand der Figuren näher erläutert:
Fig.1 zeigt schematisch als Blockschaltbild eine digitale Fernsehsignalverarbeitungsschaltung nach der Erfindung,
Fig.2 zeigt schematisch die Ermittlung des Skew-Wertes,
Fig.3 zeigt schematisch vier Zeilen des FBAS-Signals und
Fig.4 zeigt die Phasenbeziehungen des ersten und zweiten Taktes und des Rückschlagsignals.

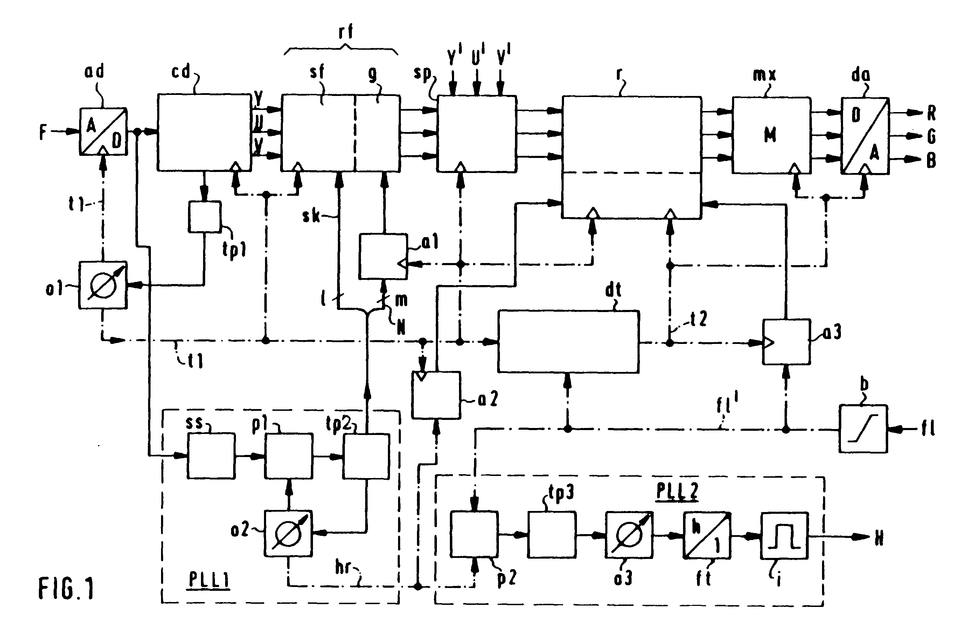

In Fig.1 ist ein FBAS-Signal F einem Analog-Digitalumsetzer ad zur Digitalisierung zugeführt. Der Digitalisierungstakt ist der erste Takt t1 der einem in der Frequenz steuerbaren ersten Oszillator o1 entstammt. Als Digitalisierungstakt dient beispielsweise eine Frequenz mit der vierfachen Farbhilfsträgerfrequenz, die auf einfache Weise aus der Farbträgerregelschleife gewonnen werden kann. In Fig.1 ist dies dadurch gekennzeichnet, daß der Steuereingang des ersten Oszillators o1 über einen ersten Tiefpaß tp1 an den Farbdecoder cd angeschlossen ist. Der Digitalisierungstakt t1 kann jedoch auch ein asynchroner Takt mit vorgegebener fester Frequenz sein.

Die Ausgangssignale des Farbdecoders cd sind die beiden Farbsignale U, V und das Helligkeitssignal Y, die den Dateneingänge eines Orthogonalfilters rf mit Skew-Filter sf und einstellbarer Verzögerungseinrichtung g zugeführt sind.

Zur Ermittlung der jeweiligen Phasenlage des FBAS-Signals F ist der Ausgang des Analog-Digitalumsetzers ad mit dem Eingang eines ersten Phasenregelkreises PLL 1 verbunden. Mittels einer Horizontal-Synchronimpuls-Abtrennstufe ss wird der zeilenfrequente Synchronimpuls abgetrennt und damit der eine Eingang eines ersten Phasenvergleichers p1 gespeist, dessen anderer Eingang mit dem Ausgangssignal eines in der Frequenz steuerbaren zweiten Oszillators o2 verbunden ist. Der Steuereingang dieses Oszillators o2 ist über einen zweiten Tiefpaß tp2 mit dem Ausgang des ersten Phasenvergleichers verbunden, wodurch der erste Phasenregelkreis geschlossen ist.

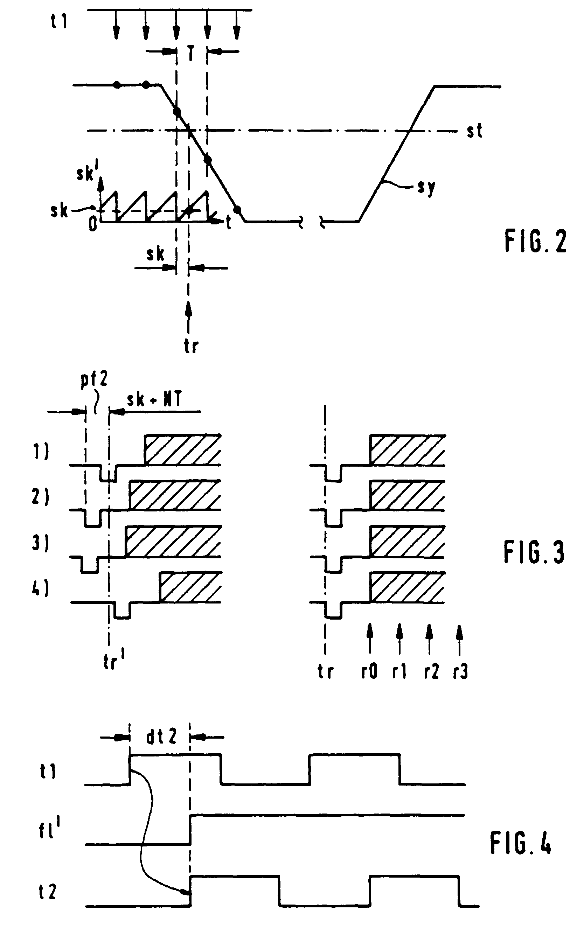

Für die Funktion dieses Regelkreises ist es unerheblich, ob er rein digital oder gemischt digital/analog aufgebaut ist. Es ist jedoch erforderlich, daß die gefilterten Phasenvergleichswerte außerhalb des ersten Phasenregelkreises PLL 1 als digitale Werte zugänglich sind, wobei die niederwertigen Stellen 1 als Skew-Wert sk dem Steuereingang des Skew-Filters sf zugeführt sind. Die höherwertigen Stellen m des Phasenvergleichssignals sind über eine Steuereinrichtung, z.B. erster Adreßgenerator a1, mit dem Steuereingang der einstellbaren Verzögerungseinrichtung g verbunden. Über die höherwertigen Stellen m wird der Periodenvielfachwert N der Abtastperiodendauer T im Phasenvergleichssignal definiert. Die niederwertigen Stellen 1 geben als Skew-Wert sk, in Taktbruchteilen den zeitlichen Verzögerungswert der Bezugsreferenz tr gegenüber dem durch den ersten Takt t1 vorgegebenen Abtastraster an, vgl. auch Fig.2.

Über den Periodenvielfachwert N stellt die Steuereinrichtung a1 die Verzögerungszeit der einstellbaren Verzögerungseinrichtung g ein. Diese kann beispielsweise ein vom ersten Takt t1 gesteuertes Schieberegister sein, dessen Anzahl von Schieberegisterstufen mindestens so groß ist wie die doppelte Anzahl des maximal zu korrigierenden Periodenvielfachwertes N. Je nach dem zu korrigierenden Periodenvielfachwert N wird das einzulesende Datenwort von einer Referenzadresse aus gerechnet N Schieberegisterstufen früher bzw. später eingeschrieben, wodurch eine nacheilende bzw. voreilende Phase ausgeglichen wird. Somit wird die Orthogonalität der Daten nach dem Orthogonalfilter rf erreicht.

Die einstellbare Verzögerungseinrichtung g im Orthogonalfilter rf ist nur dann erforderlich, wenn die eingangsseitigen FBAS-Signale F Phasensprünge aufweisen, die größer als die Abtastperiode T sind. Dies ist in der Regel beim Videorecorderbetrieb der Fall. Wenn sichergestellt ist, daß die Abweichungen kleiner als die Abtastperiode T sind, dann erübrigt sich die einstellbare Verzögerungseinrichtung g.

Wenn keine Bildsignalverarbeitung entsprechend dem in Fig.1 dargestellten Signalprozessor sp stattfinden soll, dann sind die Ausgangssignale des Orthogonalfilters rf direkt auf die Dateneingänge eines Zweitor-Schreib-Lesespeichers r geführt. Andererseits eignet sich der Ausgang des Orthogonalfilters rf besonders als Datenschnittstelle für die Signalverarbeitung in einen beliebigen Signalprozessor sp, in dem z.B. mehrdimensionale Filteralgorithmen realisiert sind. Diese orthogonale Datenschnittstelle eignet sich auch der Zuführung orthogonaler Daten Y', U', V' einer weiteren Videosignalquelle.

Die Entkopplung und Verzögerung der vom ersten bzw. zweiten Takt t1, t2 abhängigen Daten erfolgt in dem Zweitor-Schreib-Lesespeicher r, dessen Einlesetakt der erste Takt t1 und dessen Auslesetakt der zweite Takt t2 ist. Dabei kann dieser Speicher r als Speicher mit wahlfreiem Adressenzugriff (= Zweitor-RAM) (RAM= Random Access Memory) realisiert sein, dessen Einleseadressen durch ein Einlese-Adreßregister a2 und dessen Auslesadressen durch ein Auslese-Adreßregister a3 bestimmt werden. Dabei ist die Startadresse des Einlese- bzw. Auslese-Adreßregisters a2, a3 durch den Horizontal-Referenztakt hr bzw. durch ein vom Zeilenrückschlagimpuls fl abgeleitetes Rückschlagsignal fl' getriggert.

Der Zweitor-Schreib-Lese-Speicher r kann jedoch auch als FIFO-Speicher realisiert sein. Dann erzeugt der Einlese-Adreßgenerator a2 den Einlesezeiger, dessen Startadresse mit dem Horizontal-Referenztakt hr zeitlich synchronisiert ist. Der Auslese-Adreßgenerator a3 dient als Auslesezeiger, dessen Startadresse mit dem Zeilenrückschlagsignal fl' zeitlich synchronisiert ist. Dabei muß der FIFO-Speicher mindestens soviele Bilddaten speichern können, wie zur Kompensation der maximal möglichen Phasenabweichung erforderlich sind. Diese Zeitdauer gibt die Datenmenge an. Die Adressensteuerung wird jedoch besonders einfach, wenn jeweils eine ganze Bildzeile, also mehr als erforderlich, gespeichert wird.

Der Ausgang des Zweitor-Schreib-Lesespeichers r steuert eine digitale Farbmatrix mx an, deren Ausgangssignale nach der Rückwandlung im Digital-Analogumsetzer da als analoge R-, G-, B-Signale für die Bilderzeugung zur Verfügung stehen. Die Steuerung erfolgt jeweils durch den zweiten Takt t2.

Die zweite Phasenregelschleife PLL 2 enthält in Signalflußrichtung hintereinandergeschaltet einen zweiten Phasenvergleicher p2, einen dritten Tiefpaß tp3, einen dritten ziehbaren Oszillator o3, einen Frequenzteiler ft und einen Ausgangsimpulsformer i für den Horizontalimpuls H. Durch die niedere Grenzfrequenz des dritten Tiefpasses tp3 ist die Frequenz- und Phasenregeleinrichtung nur schwach an die Vorstufe angekoppelt.

Die Bezugsphase für den Leuchtfleck auf dem Bildschirm wird bekanntlich durch den Schnittpunkt des Zeilenrückschlagimpulses mit einer Spannungsreferenz bestimmt. Als Spannungsreferenz wird in der Regel eine im Versorgungsbereich (z.B. 0 bis 5 V) der Signalverarbeitungsschaltungen liegender Spannungswert verwendet, z.B. 2,5 V. Hierzu dient in Fig.1 ein Begrenzer b, dessen Durchlaßkennlinie in diesem Spannungsbereich liegt. Sein Ausgang ist das rechteckförmige Rückschlagsignal fl', dessen eine Flanke als elektronisch auswertbare Bezugsgröße für den Leuchtfleckort auf dem Bildschirm dient.

Das Rückschlagsignal fl' ist einem Eingang des zweiten Phasenvergleichers p2 zugeführt, dessen anderer Eingang mit dem Horizontal-Referenztakt hr gespeist ist. Damit die Ankopplung der zweiten Phasenregelschleife PLL 2 nur ganz niederfrequent an die Phasenlage des Zeilenrückschlagimpulses fl und an den Horizontal-Referenztakt hr und damit an das FBAS-Signal F erfolgt, ist dem zweiten Phasenvergleicher p2 der dritte Tiefpaß tp3 mit einer sehr niederen Grenzfrequenz von beispielsweise 0,01 Hz oder tiefer nachgeschaltet. Damit folgt der dritte ziehbare Oszillator o3 nur sehr niederfrequenten Schwankungen des Zeilenrückschlagimpulses fl und des FBAS-Signals F. Die zweite Phasenregelschleife PLL 2 läuft somit weitgehend autonom und muß nur die niederfrequenten Frequenz- und Phasenabweichungen der Zeilenendstufe ausgleichen.

Damit der zweite Takt t2 bis auf Phasenschwankungen die gleiche Frequenz wie der erste Takt t1 aufweist, wird der zweite Takt t2 durch einen Taktphasenschieber dt aus dem ersten Takt t1 gebildet. Ein derartiger Taktphasenschieber ist beispielsweise in EP-A 181 952 beschrieben. Hierbei läuft der erste Takt in eine Kette aus einzelnen Verzögerungsstufen ein, deren Gesamtverzögerungszeit etwa der Periodendauer des ersten Taktes t1 entspricht. Die Abgriffe aller Verzögerungsstufen sind jeweils auf eine Verriegelungsstufe geführt, deren Verriegelung durch das gemeinsam auf alle Verriegelungsstufen geführte Rückschlagsignal fl' bewirkt wird. Der jeweilige Verriegelungszustand der einzelnen Stufen ist somit von der Phasenlage zwischen dem ersten Takt t1 und dem Rückschlagsignal fl' abhängig. Der gespeicherte Phasenwert kann an den Verriegelungsstufen als Thermometercode abgegriffen werden, wobei dessen "1"-Zustände die Anzahl der erforderlichen Verzögerungsstufen angeben. Am zweckmäßigsten werden dabei zur Verzögerung des ersten Taktes t1 genau diejenigen Verzögerungsstufen verwendet, die bei der Bildung des Thermometercodes auch verwendet wurden.

In Fig.2 ist schematisch dargestellt, wie der Skew-Wert sk bezüglich einem Horizontal-Synchronimpuls sy und einem Abtrennpegel st zu bestimmen ist. Bei jedem Abtastwert t1 ist der Skew-Wert sk' null und nimmt mit steigendem Abstand linear bis zum nächsten Abtastwert zu. Der Schnittpunkt des Abtrennpegels st mit dem Horizontal-Synchronimpuls sy definiert den zeitlich/örtlichen Referenzwert tr des gesendeten FBAS-Signals F, auf den alle Videodaten zu beziehen sind. Der Skew-Wert sk wird beispielsweise rechnerisch aus den digitalisierten Abtastwerten bestimmt, die vor und nach dem Schnittpunkt liegen. Oder die Skew-Wert-Bestimmung erfolgt durch rechnerische Mittelung des gesamten Synchronimpulses oder einer abgetrennten Zone.

In Fig.3 sind in der linken Hälfte beispielsweise vier untereinanderstehende Bildzeilen mit Horizontal-Synchronimpuls und unterschiedlichem Phasenfehler schematisch dargestellt. Werden alle Zeilen ohne Phasenkorrektur dargestellt, dann weist der Bildinhalt von Zeile zu Zeile eine starke horizontale Schwankung auf. Zum Ausgleich des Phasenfehlers wird mittels der ersten Phasenregelschleife PLL 1 ein mittlerer zeitlicher Referenzwert tr' gebildet, beispielsweise der Horizontal-Referenztakt hr in Fig.1. Von diesem mittleren Referenzwert tr' wird der jeweilige Phasenfehler bestimmt, der sich aus dem Skew-Wert sk und eventuell einem ganzzahligen Periodenvielfachwert N der Abtastperiodendauer T zusammensetzt. Für die zweite Zeile ist dieser Phasenfehler pf2 dargestellt.

Die Phasenkorrektur im Orthogonalfilter rf bewirkt, daß alle nachfolgenden Zeilen orthogonal ausgerichtet sind, und daß in der einstellbaren Verzögerungseinrichtung g und in den nachfolgenden Speichereinrichtungen, also auch im Signalprozessor sp, alle untereinanderstehenden Bilddaten auch in gleichen oder in untereinanderstehenden Speicherregistern r0 bis r3 der weiteren Signalverarbeitung zur Verfügung stehen. Die unterschiedlichen Videozeilen sind gleichsam linksbündig ausgerichtet, vgl. Fig. 3, rechte Hälfte.

In Fig.4 ist schließlich die Wirkung des Taktphasenschiebers dt schematisch dargestellt, der die Phasenverschiebung des zweiten Taktes t2 genau durch die Phasenverschiebung des Rückschlagsignals fl' gegenüber dem ersten Takt t1 steuert.

## Patentansprüche

1. Digitale Fernsehsignalverarbeitungsschaltung zur Orthogonalausrichtung eines mittels eines beliebigen Abtasttaktes, einem ersten Takt (t1), digitalisierten Farb-Bild-Austast-Synchron-Signalgemisches (F) mit
- einer ersten und einer zweiten Phasenregeleinrichtung (PLL1, PLL2) zur Erzeugung eines Horizontalimpulses (H), wobei die erste und die zweite Phasenregeleinrichtung (PLL1, PLL2) schwach miteinander und an das Ausgangssignal der Horizontal-Synchronimpuls-Abtrennstufe (ss) gekoppelt sind,
- einem Skew-Filter (sf) zur datenbezogenen Phasenkorrektur von Datenwerten (Y, U, V), die aus dem digitalisierten Farb-Bild-Austast-Synchron-Signalgemisch (F) abgeleitet sind, um einen Skew-Wert (sk),
- das Skew-Filter (sf) bildet zusammen mit einer einstellbaren Verzögerungseinrichtung (g), die eine bis mehrere Abtastperioden umfassende Phasendifferenzen korrigiert, ein Orthogonalfilter (rf),
- ein in der ersten Phasenregeleinrichtung (PLLI) gebildeter Phasendifferenzwert, der aus dem Ausgangssignal einer Horizontal-Synchronimpuls-Abtrennstufe (ss) und dem Ausgangssignal eines in der Frequenz steuerbaren zweiten Oszillators (o2) der ersten Phasenregeleinrichtung (PLL1) gebildet ist, ist in zwei Stellenbereiche aufgespalten, wobei die niederwertigen Stellen (1) den Skew-Wert (sk), und die höherwertigen Stellen (m) einen ganzzahligen Periodenvielfachwert N der Abtastperiodendauer (T) bilden,
- der Periodenvielfachwert N stellt über eine Steuereinrichtung (a1) die Verzögerungszeit der einstellbaren Verzögerungseinrichtung (g) ein,
gekennzeichnet durch folgende Merkmale:
- mit dem Ausgang des Orthogonalfilters (rf) ist der Dateneingang eines Schreib-Lesespeichers (r) gekoppelt, dessen Einleseadressen von einem Einlese-Adreßgenerator (a2) erzeugt werden, wobei als Einlesetakt der erste Takt (t1) dient,
- als Auslesetakt dient dem Schreib-Lese-Speicher (r) ein zweiter Takt (t2), dessen Phase mit einem Zeilenrückschlagimpuls (f1) synchronisiert ist,
- die Ausleseadressen des Schreib-Lese-Speichers (r) sind von einem Auslese-Adreßgenerator (a3) gebildet, und
- die zweite Phasenregeleinrichtung (PLL2) regelt die Phasenlage des Horizontalimpulses (H) in Abhängigkeit von der zeitlichen Lage eines vom Zeilenrückschlagsignal (f1) abgeleiteten Rückschlagsignals (f1') aus.

2. Schaltung nach Anspruch 1, dadurch gekennzeichnet, daß der Schreib-Lesespeicher (r) und/oder die einstellbare Verzögerungseinrichtung (g) mittels einer Festkörper-Speichereinrichtung mit wahlfreiem Adressenzugriff realisiert sind, wobei die Schreib- und die Lesefunktion durch eine Zweitorsteuerung voneinander entkoppelt sind.

3. Schaltung nach Anspruch 1, gekennzeichnet durch folgende Merkmale:
- die einstellbare Verzögerungseinrichtung (g) ist ein vom ersten Takt (t1) gesteuertes Schieberegister, dessen Anzahl von Schieberegisterstufen mindestens so groß ist wie die doppelte Anzahl der maximal zu korrigierenden Periodenvielfachwerte N des jitternden Farb-Bild-Austast-Synchron-Signalgemisches (F),
- die Steuereinrichtung für das Schieberegister ist ein erster Adreßgenerator (a1), der entsprechend dem positiven bzw. negativen Periodenvielfachwert N das einzulesende Datenwort von einer Referenzadresse aus gerechnet N Schieberegisterstufen früher bzw. später einschreibt.

4. Schaltung nach Anspruch 1, dadurch gekennzeichnet, daß der Schreib-Lese-Speicher (r) ein FIFO-Speicher (= First-In-First-Out-Speicher) ist, der die jeweiligen Daten mindestens für die Zeitdauer speichert, die der zugehörigen Phasenabweichung entspricht.

5. Schaltung nach Anspruch 1, gekennzeichnet durch folgende Merkmale:
- der Schreib-Lese-Speicher (r) ist ein FIFO-Speicher, der die Daten einer Fernsehzeile speichert,
- der Einlese-Adreßgenerator (a2) dient als Einlesezeiger, dessen Startadresse mit dem Horizontal-Referenztakt (hr) zeitlich synchronisiert ist und
- der Auslese-Adreßgenerator (a3) dient als Auslesezeiger, dessen Startadresse mit dem Zeilenrückschlagsignal (f1') zeitlich synchronisiert ist.

6. Schaltung nach Anspruch 1, dadurch gekennzeichnet, daß der Ausgang des Orthogonalfilters (rf) als eine orthogonale Datenschnittstelle dient.

7. Schaltung nach Anspruch 6, dadurch gekennzeichnet, daß zwischen das Orthogonalfilter (rf) und den Schreib-Lesespeicher (r) ein Signalprozessor (sp) zur Verarbeitung orthogonaler Helligkeits- und Farbsignale mindestens einer Videosignalquelle eingefügt ist.

8. Schaltung nach Anspruch 1, dadurch gekennzeichnet, daß für Farb-Bild-Austast-Synchron-Signalgemische (F), deren maximaler Phasenjitterwert kleiner als eine Abtastperiode T ist, das Orthogonalfilter (rf) lediglich das Skew-Filter (sf) ohne einstellbare Verzögerungseinheit (g) enthält.

9. Schaltung nach Anspruch 1, dadurch gekennzeichnet, daß ein erster zienbarer Oszillator (o2) in der ersten Phasenregelschleife (PLL 1) und/oder ein zweiter ziehbarer Oszillator (o3) in der zweiten Phasenregelschleife (PLL 2) jeweils ein digitaler Oszillator ist, dessen Zeitbestimmungseinrichtung einen periodisch überlaufenden Akkumulator enthält.

## Claims

1. A digital television signal processing circuit for orthogonalizing a composite color signal (F) digitized by means of an arbitrary sampling clock, a first clock (tl), comprising:
- a first phase-locked loop (PLL1) and a second phase-locked loop (PLL2) for generating a horizontal pulse (H), the first and second phase-locked loops (PLL1, PLL2) being weakly coupled to one another and to the output signal of a horizontal-sync pulse separator (ss);
- a skew filter (sf) for correcting the phases of data values (Y, U, V) derived from the digitized composite color signal (F) by a skew value (sk);
- the skew filter (sf), together with a variable delay device (g) which corrects large phase differences covering one to several sampling periods, forms an orthogonal filter (rf);
- a phase-difference value formed in the first phase-locked loop (PLL1) from the output signal of the horizontal-sync pulse separator (ss) and the output signal of a second frequency-variable oscillator (02) contained in the first phase-locked loop (PLL1) is split into two bit ranges, with the low-order bits (1) forming the skew value (sk), and the higher-order bits (m) forming an integral multiple N of the sampling period; and
- the multiple N of the sampling period adjusts the delay of the variable delay device (g) via a control device (a1),
characterized by the following features:
- The output of the orthogonal filter (rf) is coupled to the data input of a read/write memory (r) whose write addresses are generated by a write-address generator (a2), with the first clock (tl) serving as a write clock;
- a second clock (t2), whose phase is synchronized with a horizontal flyback pulse (f1), serves as a read clock for the read/write memory (r);
- the read addresses of the read/write memory (r) are generated by a read-address generator (a3); and
- the second phase-locked loop (PLL2) controls the phase of the horizontal pulse (H) in accordance with the temporal position of a flyback signal (f1') derived from the horizontal flyback signal (f1).

2. A circuit as claimed in claim 1, characterized in that the read/write memory (r) and/or the variable delay device (g) are implemented with a random-access solid-state memory device, with the write function and the read function being separated from each other by a dual-port control.

3. A circuit as claimed in claim 1, characterized by the following features:
- The variable delay device (g) is a shift register which is controlled by the first clock signal (t1) and whose number of stages is at least equal to twice the maximum number of multiples N of the sampling period of the jittered composite color signal (F) to be corrected; and
- the control device for the shift register is a first address generator (a1) which, depending on the positive or negative multiple N of the sampling period, causes the respective data word to be written N shift-register stages earlier or later, respectively, as counted from a reference address.

4. A circuit as claimed in claim 1, characterized in that the read/write memory (r) is a FIFO (first-in first-out) memory which stores the respective data for at least the time which corresponds to the associated phase deviation.

5. A circuit as claimed in claim 1, characterized by the following features:
- The read/write memory (r) is a FIFO memoy which stores the data of one television line;
- the write-address generator (a2) serves as a write pointer whose start address is synchronized with the horizontal reference clock (hr); and
- the read-address generator (a3) serves as a read pointer whose start address is synchronized with the horizontal flyback signal (f1').

6. A circuit as claimed in claim 1, characterized in that the output of the orthogonal filter (rf) serves as an orthogonal data interface.

7. A circuit as claimed in claim 6, characterized in that a signal processor (sp) for processing orthogonal luminance and color signals from at least one video-signal source is interposed between the orthogonal filter (rf) and the read/write memory (r).

8. A circuit as claimed in claim 1, characterized in that for composite color signals (f) whose maximum phase-jitter value is less than one sampling period T, the orthogonal filter (rf) contains only the skew filter (sf) and no variable delay device (g).

9. A circuit as claimed in claim 1, characterized in that a first variable-frequency oscillator (o2) in the first phase-locked loop (PLL 1) and/or a second variable-frequency oscillator (o3) in the second phase-locked loop (PLL 2) are respective digital oscillators whose respective timing devices comprise periodically overflowing accumulators.

## Revendications

1. Circuit de traitement de signal de télévision numérique pour le redressement orthogonal d'un mélange de signaux de synchronisation d'un signal composé de chrominance (F) qui est numérisé au moyen d'une cadence de balayage arbitraire, une première cadence (t1), comprenant
- une première et deuxième boucles à phase asservie (PLL1, PLL2) pour la production d'une impulsion de ligne (H), les première et deuxième boucles à phase asservie (PLL1, PLL2) étant faiblement couplées entre elles et avec le signal de sortie de l'étage séparateur de l'impulsion de synchronisation de ligne (ss),
- un filtre de défaut en losange (sf) pour la correction de phase, relative à des valeurs de données (Y, U et V) qui sont dérivées du mélange de signaux de synchronisation d'un signal composé de chrominance (F) numérisé, pour obtenir une valeur de déformation en losange (sk),
- le filtre de défaut en losange (sf) constitue, en association avec un dispositif de retardement variable (g), qui corrige des différences de phase comprenant une ou plusieurs périodes de balayage, un filtre orthogonal (rf),
- une valeur de différence de phase, formée dans la première boucle à phase asservie (PLL1), qui est constituée du signal de sortie d'un étage séparateur de l'impulsion de synchronisation de ligne (ss) et du signal de sortie d'un deuxième oscillateur (o2) commandable en fréquence de la première boucle à phase asservie (PLL1), est divisée en deux domaines de poids, les poids de faible valeur (I) formant la valeur de déformation en losange (sk) et les poids de forte valeur (m) formant une valeur multiple entière N de la durée de la période de balayage (T),
- la valeur multiple N de la période détermine, au moyen d'un dispositif de commande (a1), le temps de retardement du dispositif de retardement variable (g),
caractérisé par les particularités suivantes :
- l'entrée de données d'une mémoire de lecture-écriture (r) dont les adresses d'écriture sont fournies par un générateur d'adresses d'écriture (a2), la première cadence (t1) servant de cadence d'écriture, est couplée avec la sortie du filtre orthogonal (rf),
- une deuxième cadence (t2) dont la phase est synchronisée avec une impulsion de retour de lignes (f1) sert de cadence de lecture pour la mémoire de lecture-écriture (r),
- les adresses de lecture de la mémoire de lecture-écriture (r) sont formées par un générateur d'adresses de lecture (a3), et
- la deuxième boucle à phase asservie (PLL2) régule la relation de phase de l'impulsion de ligne (H) en fonction de la position temporelle d'un signal de retour de lignes (f1') dérivé d'une impulsion de retour de lignes (f1).

2. Circuit selon la revendication 1, caractérisé en ce que la mémoire de lecture-écriture (r) et/ou le dispositif de retardement variable (g) sont réalisés au moyen d'un dispositif de mémoire intégré à accès direct, les fonctionnements en écriture et en lecture étant découplés l'un de l'autre au moyen d'une commande à deux portes.

3. Circuit selon la revendication 1, caractérisé par les particularités suivantes :
- le dispositif de retardement variable (g) est un registre à décalage commandé par la première cadence (t1) et dont le nombre d'étages de registres à décalage est au moins égal au double de la valeur multiple N de la période à corriger du mélange de signaux de synchronisation du signal composé de chrominance (F) qui est instable,
- le dispositif de commande pour le registre à décalage est un premier générateur d'adresses (a1) qui, en fonction de la valeur positive ou négative N multiple de la période, écrit le mot de données plus tôt ou plus tard par une adresse de référence à partir de N, calculé, étages de registre à décalage.

4. Circuit selon la revendication 1, caractérisé en ce que la mémoire de lecture-écriture (r) est une mémoire FIFO (premier entré, premier sorti) qui mémorise les données respectives au moins pendant la durée de temps qui correspond à l'écart de phase.

5. Circuit selon la revendication 1, caractérisé par les particularités suivantes :
- la mémoire de lecture-écriture (r) est une mémoire FIFO qui mémorise les données d'une ligne de télévision,
- le générateur d'adresses d'écriture (a2) sert de pointeur d'écriture dont l'adresse de départ est synchronisée de manière temporelle avec la cadence de référence de lignes (hr) et
- le générateur d'adresses de lecture (a3) sert de pointeur de lecture dont l'adresse de départ est synchronisée de manière temporelle avec le signal de retour de lignes (f1').

6. Circuit selon la revendication 1, caractérisé en ce que la sortie du filtre orthogonal (rf) sert d'interface de données orthogonales.

7. Circuit selon la revendication 1, caractérisé en ce que, entre le filtre orthogonal (rf) et la mémoire de lecture-écriture (r), est inséré un processeur de signaux (sp) pour le traitement de signaux de luminosité et de chrominance d'au moins une source de signaux vidéo.

8. Circuit selon la revendication 1, caractérisé en ce que, pour des mélanges de signaux de synchronisation d'un signal composé de chrominance (F) dont la valeur maximale d'instabilité de phase est plus petite qu'une période T de balayage, le filtre orthogonal (rf) contient seulement le filtre de défaut en losange (sf) sans dispositif de retardement variable (g).

9. Circuit selon la revendication 1, caractérisé en ce qu'un deuxième oscillateur (o2) commandable disposé dans la première boucle à phase asservie (PLL1) et/ou un troisième oscillateur commandable (o3) disposé dans la deuxième boucle à phase asservie (PLL2) est, à chaque fois, un oscillateur numérique dont le dispositif de détermination du temps contient un registre accumulateur à débordement cyclique.
